# DEMANDE DE BREVET EUROPEEN

(11) **EP 1 396 882 A2**
(43) Date de publication de la demande: **10.03.2004**
(21) Numéro de dépôt: 03292012.6
(22) Date de dépôt: 11.08.2003
(51) Int. Cl.: H01L 21/336, H01L 21/768, H01L 21/762

(54) **Procédé de réalisation d'un composant électronique intégré et dispositif électrique incorporant tel composant**

(30) Priorité: 06.09.2002 FR 0211054; 06.03.2003 FR 0302772
(71) Demandeur: STMicroelectronics S.A., 92120 Montrouge (FR)
(72) Inventeur: Bustos, Jessy, 38660 Le Touvet (FR); Coronel, Philippe, 38530 Barraux (FR); Regnier, Christophe, 38660 St Hilaire du Touvet (FR); Wacquant, Francois, 38330 St. Ismier (FR); Tavel, Brice, 38100 Grenoble (FR); Skotnicki, Thomas, 38920 Crolles (FR)
(74) Mandataire: Loisel, Bertrand

(57) **Abrégé**

Un procédé de réalisation d'un composant électronique comprend le recouvrement d'un substrat (100) par une portion (P) délimitant avec le substrat un volume (V) rempli au moins partiellement d'un matériau temporaire, l'évacuation du matériau temporaire par une cheminée (C) d'accès audit volume, et le dépôt d'un matériau de remplissage (7) dans ledit volume à partir de précurseurs amenés par la cheminée. Le procédé est particulièrement adapté pour la réalisation d'une grille d'un transistor de type MOS. Dans ce cas, le matériau de remplissage est conducteur, et un matériau isolant électrique de revêtement (8) peut aussi être déposé dans ledit volume avant le matériau de remplissage conducteur.

## Description

La présente invention concerne un procédé de fabrication d'un composant électronique intégré.

Elle concerne plus particulièrement le procédé de fabrication d'un tel composant comprenant un volume limité d'un matériau déterminé, dont les dimensions doivent être précisément définies et reproduites identiquement lors d'une fabrication en grande série.

L'augmentation du niveau d'intégration des circuits électroniques conduit à une réduction des dimensions géométriques des composants qui constituent ces circuits. A titre d'exemple, la technologie de fabrication des transistors à effet de champ, ou transistors MOS («Metal-Oxide-Semiconductor»), est désignée par la largeur de la grille de ces transistors, mesurée selon la direction de passage du courant électrique entre la source et le drain des transistors. Ainsi, les technologies de fabrication de composants semiconducteurs à 0,13 et 0,10 micromètre correspondent à des transistors dont les grilles ont des largeurs respectives de 130 et 100 nanomètres.

Pour fabriquer de façon reproductible des composants ayant de tels niveaux d'intégration, il est nécessaire que les procédés utilisés permettent un contrôle très précis des dimensions géométriques des parties des composants qui déterminent les caractéristiques électriques finalement obtenues. Ceci est en particulier le cas des grilles des transistors MOS.

Une méthode de formation d'un matériau de forme extérieure déterminée sur un substrat consiste à déposer, dans une première étape, une couche sensiblement uniforme de ce matériau sur le substrat, puis, dans une seconde étape, à retirer ce matériau par gravure en dehors d'une partie du substrat définie par un masque. Le procédé de gravure doit être choisi de façon à ce que ledit matériau dans sa forme définitive présente des flancs conformes à la géométrie désirée, pouvant être, par exemple, des flancs plans et perpendiculaires à la surface du substrat.

Or, lorsque ledit matériau est, en particulier, un métal, de tels flancs formés par gravure d'une couche préalablement déposée sont imparfaits à l'échelle des niveaux d'intégration actuellement recherchés. Ils présentent notamment une inclinaison par rapport à une direction perpendiculaire à la surface du substrat, voire des ondulations selon cette direction.

Par ailleurs, le procédé de gravure utilisé doit être sélectif entre le matériau déposé sur le substrat et le matériau du substrat lui-même, afin d'éliminer le matériau déposé en dehors de la forme finale désirée, sans enlever de matériau du substrat. A défaut de cette sélectivité, la surface du substrat est modifiée lors de la gravure, empêchant un contrôle précis de la hauteur, par rapport à la surface du substrat, du matériau déposé restant après l'étape de gravure. Cette sélectivité représente une contrainte dans le choix des matériaux du composant, qui peut être incompatible avec certaines des caractéristiques recherchées pour ledit composant.

Le procédé Damascène connu de l'Homme du métier, ou sa variante «dual Damascène», constitue une seconde méthode de formation d'un motif de forme déterminée sur un substrat. Ce procédé consiste à déposer sur le substrat une couche d'un matériau externe dans laquelle on forme une cavité servant de moule pour le matériau auquel une forme déterminée doit être conférée. La cavité est remplie de ce dernier matériau en formant un excès au dessus de la cavité, afin de garantir un remplissage complet de celle-ci. L'excès de matériau de remplissage est ensuite éliminé par polissage.

Un inconvénient des procédés Damascène et «dual Damascène» provient du polissage final. En effet, la vitesse de polissage dépend du matériau retiré, c'est-à-dire le matériau externe ou le matériau de remplissage, si bien que des zones présentant une densité élevée de motifs sont érodées lors du polissage à une vitesse différente de celle des zones présentant une densité plus faible de motifs. Une perte de planéité de la surface de polissage en résulte, source de disparités au sein d'une série de composants fabriqués en utilisant ce type de procédés. Cette perte de planéité à l'issue du polissage peut correspondre à des variations d'épaisseur de la couche de matériau externe atteignant 150 nanomètres, incompatibles avec les technologies à 0,10 et 0,13 micromètre qui requièrent un contrôle de cette épaisseur à 10 nanomètres près, environ. Cette exigence de planéité deviendra encore plus sévère pour les futures technologies de fabrication des circuits intégrés.

Pour certaines configurations géométriques, ces variations d'épaisseur peuvent en outre provoquer un enlèvement insuffisant, lors du polissage, de l'excès de matériau de remplissage. Lorsque le matériau de remplissage est conducteur, des parties résiduelles de cet excès peuvent provoquer ultérieurement un court-circuit électrique, pendant l'utilisation du dispositif électrique qui incorpore un tel composant.

Un but de la présente invention consiste donc à réaliser des motifs de matériaux déterminés sur un substrat en permettant un contrôle précis des dimensions géométriques desdits motifs.

La présente invention propose un procédé de réalisation d'un composant électronique qui comprend les étapes suivantes :
a- couvrir une surface sensiblement plane d'un substrat d'une portion délimitant avec le substrat un volume rempli au moins partiellement d'un matériau temporaire ;
b- évacuer le matériau temporaire dudit volume par une cheminée s'étendant entre ledit volume et une surface d'accès ;
c- introduire un matériau de remplissage dans ledit volume à partir de premiers précurseurs amenés par la cheminée.

Selon l'invention, le volume dans lequel est introduit le matériau de remplissage est séparé de la surface d'accès, de sorte que les dimensions dudit volume initialement fixées sont définitivement conservées jusqu'à la fin du procédé de réalisation du composant électronique.

Un avantage du procédé de l'invention est d'éliminer les contraintes portant sur le choix du matériau de remplissage, liées à la sélectivité des techniques de retrait du matériau de remplissage par rapport au matériau du substrat et/ou aux matériaux délimitant ledit volume. En effet, le procédé de l'invention ne comporte pas d'étape de retrait du matériau de remplissage hors dudit volume. De plus, selon le procédé, le matériau de remplissage est formé après l'évacuation du matériau temporaire, de sorte que l'étape d'évacuation du matériau temporaire ne limite pas le choix du matériau de remplissage.

Un autre avantage du procédé de l'invention réside dans l'absence de pollutions chimiques et de particules solides générées lors des étapes a,b et c. Le procédé est alors compatible avec un niveau de pureté élevé des matériaux du composant électronique, notamment du matériau de remplissage, nécessaire pour l'obtention de caractéristiques électriques particulièrement exigeantes.

Un autre avantage encore du procédé de l'invention est de permettre un chauffage du substrat et des matériaux présents sur le substrat avant l'étape c du procédé. Ainsi, l'utilisation d'un matériau de remplissage susceptible d'être dégradé par un traitement thermique est compatible avec un chauffage de certains au moins des autres matériaux du composant électronique, pour leur conférer des propriétés déterminées.

Dans une configuration géométrique particulière à laquelle s'applique l'invention, la cheminée possède une section parallèle à la surface du substrat sensiblement plus petite qu'une projection dudit volume sur la surface du substrat. Le procédé de l'invention permet alors d'introduire le matériau de remplissage dans ledit volume par une ouverture réduite, particulièrement compatible avec la réalisation de composants électroniques présentant un niveau d'intégration élevé.

Dans une configuration géométrique selon laquelle la cheminée est sensiblement perpendiculaire à la surface du substrat, la cheminée permet en outre un accès à une partie enfouie du composant électronique en cours de réalisation, c'est-à-dire à une partie non-adjacente à ladite surface d'accès. Le procédé de l'invention est alors particulièrement adapté à la réalisation de structures ayant plusieurs niveaux superposés, contribuant à une diminution du coût du composant électronique, par réduction de la dimension du substrat.

Ledit volume peut être disposé, en particulier, juste au dessous de la surface du substrat ou juste au dessus de cette surface. Dans le premier cas, le procédé peut comprendre les deux étapes suivantes, effectuées avant l'étape a :
- retirer une partie d'un matériau du substrat correspondant audit volume ;
- remplir au moins partiellement ledit volume par le matériau temporaire.

Dans le cas où ledit volume est situé au dessus de la surface du substrat, le procédé peut comprendre une formation, avant l'étape a, d'un motif sur la surface du substrat comprenant ledit volume rempli au moins partiellement par le matériau temporaire.

Plusieurs méthodes distinctes peuvent être utilisées pour recouvrir la surface du substrat de ladite portion.

Une première méthode consiste à former ladite portion sur un autre substrat, dit support temporaire, par dépôts successifs de matériaux appropriés sur ce support temporaire. Ladite portion portée initialement par le support temporaire est ensuite transférée sur la surface du substrat destiné à porter le composant électronique, selon l'un des procédés de transfert connus de l'Homme du métier, tel que, par exemple, le procédé dit de collage moléculaire (connu aussi sous l'appellation de «wafer bonding»). Le support temporaire est ensuite retiré, par exemple par polissage à partir d'une surface du support temporaire opposée à ladite portion. Ce retrait peut être éventuellement complété par une gravure par plasma (ou «dry etching»).

Selon une seconde méthode, une partie au moins de ladite portion comprend des matériaux formés directement sur la surface du substrat destiné à porter le composant électronique.

La cheminée d'accès audit volume est ensuite formée dans ladite portion par retrait d'au moins un matériau externe audit volume, entre la surface d'accès et ledit volume.

On évacue alors le matériau temporaire dudit volume par la cheminée en utilisant un procédé de retrait connu de l'Homme du métier, tel que, par exemple, une gravure isotrope du matériau temporaire. Une telle gravure isotrope peut être réalisée au moyen d'un plasma («dry etching») pénétrant par la cheminée jusqu'au matériau temporaire dans ledit volume, ou en introduisant par la cheminée une solution liquide incorporant des réactifs chimiques déterminés («chemical etching»). Dans le cas d'une gravure utilisant une solution liquide, une gravure électrochimique peut en particulier être mise en oeuvre en appliquant une tension électrique entre le matériau temporaire et une électrode plongée dans la solution.

Les composants du plasma ou les réactifs chimiques de la solution utilisée peuvent être choisis de façon appropriée pour éliminer sélectivement ou, tout au moins, principalement le matériau temporaire par rapport aux autres matériaux de ladite portion, externes audit volume. Pour cela, le matériau temporaire peut être choisi parmi les matériaux suivants : silicium, un alliage de silicium et de germanium, la silice et le nitrure de silicium, pour lesquels des procédés de retrait sélectifs par rapport à des matériaux externes audit volume convenablement sélectionnés sont connus de l'Homme du métier.

Ledit volume occupé par le matériau temporaire peut aussi être délimité, sur au moins une partie de sa limite, par au moins un matériau spécifique résistant à l'évacuation du matériau temporaire. Ce matériau spécifique constitue alors une barrière d'arrêt de la gravure isotrope entre le matériau temporaire et un matériau de ladite portion externe audit volume.

Un premier matériau résistant à l'évacuation du matériau temporaire peut, notamment, être disposé initialement sous forme d'une couche d'arrêt entre le matériau temporaire et le substrat. Une telle configuration permet d'utiliser en particulier un même matériau pour le substrat et pour le matériau temporaire tel que, par exemple, du silicium. Eventuellement, ledit premier matériau de la couche d'arrêt peut être retiré entre les étapes d'évacuation du matériau temporaire et d'introduction du matériau de remplissage. Ledit volume correspond alors à une réunion de l'espace initialement occupé par le matériau temporaire et de l'espace occupé par la couche d'arrêt.

Lors de l'étape c du procédé de l'invention, le matériau de remplissage peut être simultanément formé dans ledit volume et dans la cheminée. Pour certaines applications du procédé de l'invention, un comblement complet dudit volume par le matériau de remplissage peut ne pas être nécessaire. En particulier, un dépôt du matériau de remplissage sur les parois internes dudit volume peut être suffisant, tout en laissant vide une partie centrale dudit volume.

Selon une mise en oeuvre particulière de l'invention, un matériau de revêtement est introduit dans ledit volume avant le matériau de remplissage, à partir de seconds précurseurs amenés par la cheminée. Un tel matériau de revêtement peut avoir différentes fonctions au sein du composant électronique final ou lors de sa réalisation. De telles fonctions sont, par exemple, une amélioration de l'adhésion du matériau de remplissage sur les matériaux des parois dudit volume, une fonction de promoteur de croissance du matériau de remplissage lors de l'étape c du procédé, ou encore une isolation chimique ou électrique entre le substrat et le matériau de remplissage.

Le procédé de l'invention est particulièrement adapté pour la réalisation de grilles de transistors à effet de champ. Dans ce cas, un matériau de remplissage conducteur électrique et un matériau de revêtement isolant électrique peuvent être utilisés pour constituer respectivement la grille et l'oxyde d'isolation de la grille du transistor. Lorsque la cheminée est aussi au moins partiellement remplie du matériau de remplissage conducteur, elle peut constituer une connexion électrique reliant la grille du transistor final.

L'invention concerne aussi un composant électronique, réalisé selon un procédé tel que décrit précédemment. Elle concerne encore un dispositif électrique comprenant un tel composant. Ledit composant peut être, en particulier, un transistor à effet de champ dont la grille est élaborée en utilisant le procédé de l'invention.

D'autres particularités et avantages de la présente invention apparaîtront dans la description ci-après de deux exemples de mise en oeuvre non limitatifs, en référence aux dessins annexés, dans lesquels :
- les figures 1 à 9 illustrent différentes étapes de réalisation d'un transistor à effet de champ en utilisant un procédé selon l'invention ;
- la figure 9a illustre une variante de réalisation d'un transistor à effet de champ en utilisant le procédé de l'invention ;
- les figures 10 à 17 illustrent différentes étapes de réalisation d'un ensemble de pistes de transmission rapide de signaux électriques en utilisant un procédé selon l'invention.

Dans ces figures, pour raison de clarté, les dimensions des différentes parties de composants représentées ne sont pas en proportion avec leurs dimensions réelles. Toutes ces figures sont des vues en coupe d'au moins un substrat et de différents matériaux disposés sur une surface plane de ce substrat. Les vues en coupe sont considérées dans des plans perpendiculaires à la surface du substrat. Sur ces figures, des références identiques correspondent à des éléments analogues. On note D une direction perpendiculaire à la surface du substrat, orientée vers le haut des figures, le substrat étant placé dans la partie inférieure des figures. Les termes «au-dessus de», «au-dessous de», «sur», «sous», «supérieur» et «inférieur» utilisés dans la suite font référence à cette orientation.

Le procédé de l'invention est maintenant décrit en détail dans le cadre de la réalisation d'un transistor à effet de champ, ou transistor MOS, dont la grille est en matériau métallique. Une telle grille métallique confère au transistor MOS des caractéristiques dynamiques supérieures à celles d'un transistor MOS équivalent dont la grille est en silicium polycristallin conducteur, et permet une réduction particulière de la taille de ce type de transistors.

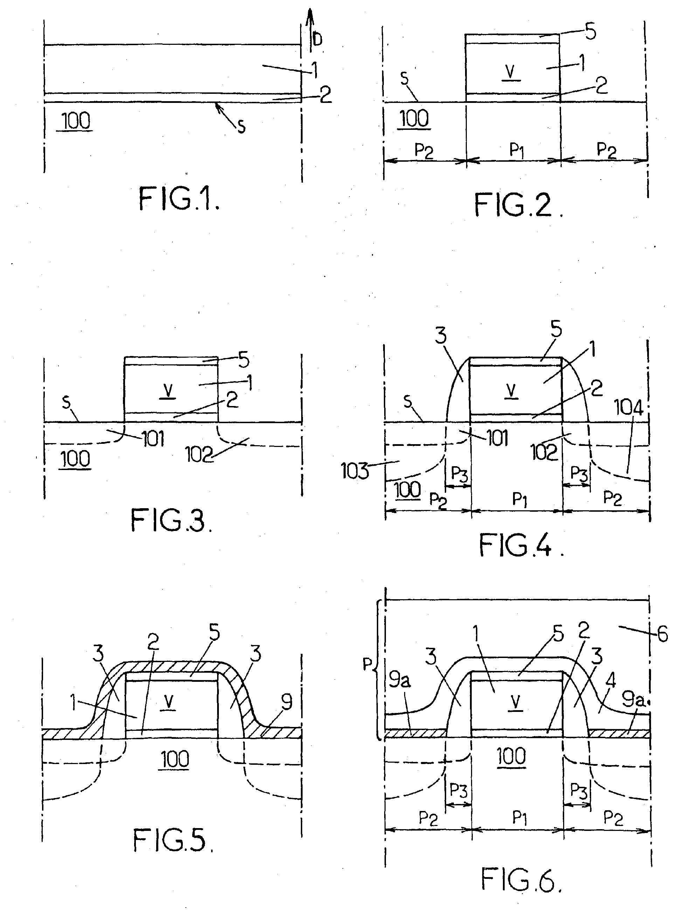

Selon la figure 1, une portion de surface plane S d'un substrat 100, par exemple en silicium monocristallin, est recouverte d'une couche 2 d'un premier matériau. La couche 2 est elle-même recouverte d'une couche de matériau temporaire 1. Les couches du matériau temporaire 1 et dudit premier matériau 2 sont sensiblement uniformes sur la portion de surface S, d'épaisseurs respectives 150 nanomètres et 10 nanomètres, par exemple, selon la direction D. Ledit premier matériau de la couche 2 est choisi pour résister à un procédé d'évacuation du matériau temporaire de la couche 1. A titre d'exemple, le matériau temporaire est du silicium, et ledit premier matériau est de la silice SiO₂.

Un matériau de masquage 5, par exemple en nitrure de silicium Si₃N₄, est ensuite déposé sur la couche de matériau temporaire 1, avec une épaisseur pouvant être de 10 nanomètres, environ. Alternativement, de la silice SiO₂ peut aussi constituer le matériau de masquage 5.

On retire alors le matériau de masquage 5 et le matériau temporaire 1 en dehors d'une zone P1 du substrat 100 (figure 2). Ce retrait est effectué selon l'une des méthodes connues de l'Homme du métier, en utilisant par exemple un masque lithographié de résine recouvrant le matériau 5 dans la zone P1, puis en exposant le substrat à au moins un plasma de gravure adapté en fonction du matériau 5 puis du matériau 1 en cours d'enlèvement. Ce retrait définit le volume V, correspondant à la réunion de l'espace occupé par le matériau temporaire 1 restant dans la zone P1 à l'issue de cette gravure et de l'espace occupé par la partie du matériau 2 située entre le matériau temporaire 1 restant et le substrat 100. Le matériau temporaire 1 résiduel peut être qualifié de «fausse grille», étant donné que son rôle est de repérer l'emplacement de la grille définitive du transistor pendant une partie du procédé d'élaboration du transistor. Les dimensions de cette fausse grille parallèlement à la surface S sont, par exemple, 15 à 130 nanomètres dans le plan de la figure 2 et 120 à 200 nanomètres dans la direction perpendiculaire au plan de la figure 2.

On retire ensuite le matériau 2 de la surface S, dans des secondes zones P2 du substrat disjointes de la première zone P1. En particulier les zones P2 peuvent s'étendre de part et d'autre de la zone P1, en étant adjacentes à celle-ci (figure 2). Ce retrait du matériau 2, dans le cas où celui-ci est de la silice, peut être effectué par gravure chimique isotrope, notamment de type flash. Une telle gravure utilise une solution contenant de l'acide fluorhydrique HF, éventuellement atténué par du fluorure d'ammonium NH₄F.

On procède alors à une première implantation de dopage dans deux portions 101 et 102 du substrat 100 (figure 3), appelées extensions, s'étendant de part et d'autre de la zone P1. Cette première implantation, peu profonde sous la surface S à l'intérieur du substrat 100, est effectuée de façon connue de l'Homme du métier, notamment en étant limitée transversalement par les extrémités opposées de la fausse grille 1. Un tel procédé d'implantation est dit auto-aligné par rapport à l'emplacement de la grille.

On dépose ensuite, de façon connue de l'Homme du métier, un second matériau 3 résistant à l'évacuation du matériau temporaire 1, dans une troisième zone P3 de la surface S entourant la zone P1 (figure 4). Le second matériau résistant 3 est par exemple du nitrure de silicium Si₃N₄, déposé initialement sous forme d'une couche continue recouvrant toute la surface S, puis gravé de façon isotrope selon la direction D. Le second matériau résistant 3 entoure ainsi la fausse grille 1, parallèlement à la surface S, jusqu'à la hauteur, selon la direction D, de la surface supérieure du matériau de masquage 5. Il constitue l'espaceur du transistor final, disposé entre la grille et la source de ce transistor d'une part, et entre la grille et le drain de ce transistor d'autre part.

On procède alors à une seconde implantation de dopage, de même type que la première implantation, dans deux portions 103 et 104 du substrat 100 (figure 4) correspondant aux zones de source et de drain du transistor final. Ces portions 103 et 104 s'étendent respectivement à partir du droit de chaque extrémité extérieure de l'espaceur 3, de chaque côté de l'espaceur 3, et s'étendent dans le substrat 100 jusqu'à une profondeur sous la surface S supérieure à la profondeur maximale des extensions 101 et 102.

On recouvre alors la surface S d'une couche continue sensiblement uniforme 9 d'un métal (figure 5). Le métal utilisé est choisi pour former, lorsqu'il est chauffé, un alliage conducteur avec du matériau silicium sur lequel il est déposé. De façon usuelle, le cobalt est utilisé et forme l'alliage CoSi₂. D'autres métaux peuvent être alternativement utilisés, dans la mesure où ils forment un alliage conducteur similaire avec le silicium. L'alliage métal-silicium, ou siliciure du métal, se forme dans les zones où le métal 9 est en contact direct avec le matériau silicium du substrat 100, c'est-à-dire dans les zones P2 en dehors des zones P3. L'espaceur 3 et le matériau de masquage 5 empêchent la formation de siliciure à partir du matériau silicium de la fausse grille 1. Après le chauffage de siliciuration, le métal 9 résiduel, en dehors des parties du métal 9 qui ont formé le siliciure, est éliminé par dissolution dans une solution chimique acide ou par gravure au moyen d'un plasma accéléré contre la surface S avec une tension électrique modérée. Les zones restantes 9bis de siliciure du métal forment les zones de contact électrique de la source et du drain du transistor final.

On dépose ensuite un premier matériau externe 4, de façon continue et sensiblement uniforme dans les zones P1 et P3, ainsi que dans une quatrième zone du substrat entourant la zone P3. Sur la figure 6, le matériau 4 est déposé sous forme d'une couche recouvrant l'ensemble de la portion de surface S, y compris l'espaceur 3 et la couche de masquage 5 au dessus du volume V. Ladite quatrième zone correspond alors à la zone complémentaire des zones P1 et P3 par rapport à l'ensemble de la portion de surface S. Le matériau 4 peut être, en particulier, du nitrure de silicium Si₃N₄. Le procédé de dépôt du matériau 4 peut être, par exemple, un procédé analogue à celui utilisé pour le matériau de masquage 5. L'épaisseur du matériau 4 selon la direction D est, par exemple, comprise entre 30 et 40 nanomètres.

On recouvre ensuite la portion de surface S d'une couche d'un second matériau externe 6 jusqu'à, par exemple, une hauteur comprise entre 500 et 800 nanomètres au dessus de la surface S du substrat 100. Ce second matériau externe peut être choisi, en particulier, pour être déposé rapidement. Ce peut être, par exemple, de la silice SiO₂ obtenue par dépôt chimique en phase vapeur assisté par plasma (PECVD ou «Plasma Enhanced Chemical Vapor Deposition»). La surface supérieure du matériau 6 est ensuite polie de façon à former une surface plane sensiblement parallèle à la surface S du substrat 100.

Dans cette première mise en oeuvre du procédé de l'invention, les matériaux 3-6 constituent ladite portion du procédé de l'invention, référencée P sur la figure 6, dont est recouverte la surface S du substrat 100.

De façon connue, les propriétés semiconductrices des portions du substrat implantées 101-104 ne sont définitivement obtenues qu'après un chauffage spécifique à haute température, par exemple à 1000°C environ, appelé «recuit d'activation». Ce chauffage n'altère aucun des matériaux portés par le substrat 100 à ce niveau d'exécution du procédé, ces matériaux étant du polysilicium pour le matériau temporaire 1, de la silice SiO₂ pour ledit premier matériau 2 résistant à l'évacuation du matériau temporaire et pour le second matériau externe 6, du nitrure de silicium Si₃N₄ pour le second matériau 3 résistant à l'évacuation du matériau temporaire, pour le premier matériau externe 4 et pour le matériau de masquage 5, et le siliciure de métal 9bis qui possède un comportement thermique réfractaire. Ainsi, grâce au procédé de l'invention, une grille définitive métallique peut être combinée avec le recuit d'activation à haute température, notamment à une température supérieure à la température de fusion du métal de la grille, la grille métallique étant formée après le recuit d'activation.

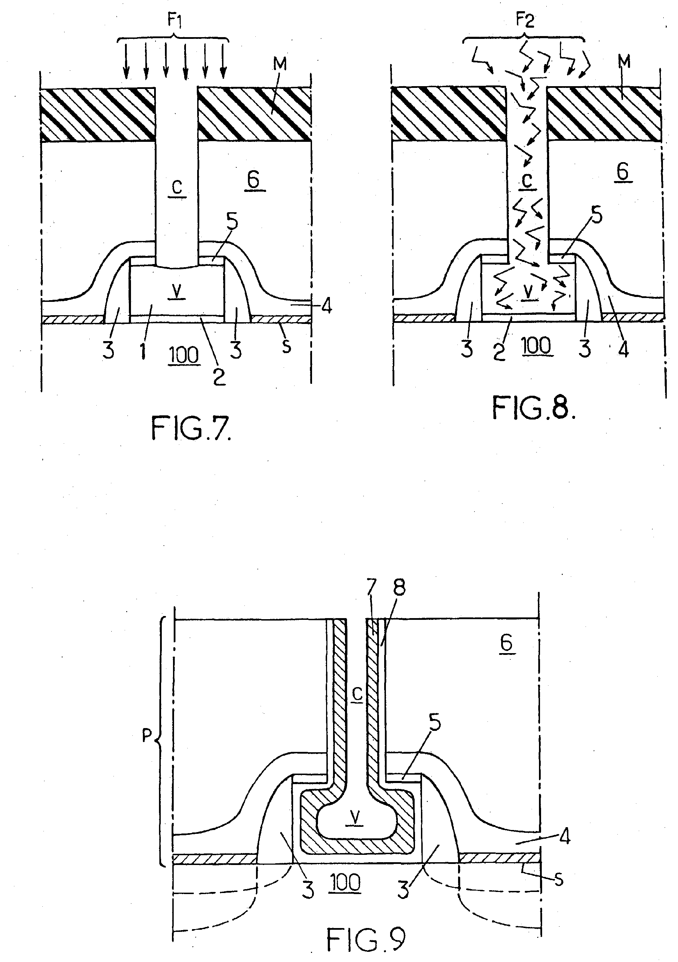

Une cheminée C est alors aménagée entre la surface supérieure du second matériau externe 6 et le volume V (figure 7). Pour cela, selon un procédé lithographique connu de l'Homme du métier, on dépose sur le matériau 6 un masque de gravure M en résine comportant une ouverture destinée à définir la section de la cheminée C parallèlement à la surface S. Le substrat 100 portant le masque M est ensuite exposé à un plasma de gravure directionnelle. Dans un tel procédé de gravure, un flux parallèle de particules accélérées F1 est envoyé en direction du substrat 100, qui retire les matériaux successifs apparaissant sous l'ouverture du masque M. Ce retrait est effectué selon un front de progression perpendiculaire à la direction du flux F1, et se déplaçant parallèlement à la direction du flux F1. Le flux F1 est parallèle à la direction D. Des molécules fluorées telles que C₄F₈ sont introduites dans le plasma de gravure directionnelle pour augmenter, par effet chimique, la vitesse de gravure du second matériau externe 6, en particulier. Le second matériau externe 6 est ainsi retiré selon une colonne parallèle à la direction D, puis le premier matériau externe 4, et le matériau de masquage 5. La cheminée C est ainsi formée.

Le substrat 100 toujours recouvert du masque de gravure M est ensuite exposé à un plasma de gravure isotrope du matériau 1 de la fausse grille (figure 8). Un tel plasma contient, par exemple, des molécules d'hexafluorure de soufre SF₆ ou de chlorure d'hydrogène HCl permettant de retirer sélectivement le matériau silicium 1 de la fausse grille sans agresser les matériaux 2 et 6 de silice, ni l'espaceur 3 et le matériau de masquage 5 de nitrure de silicium. Un flux des particules du plasma de gravure isotrope F2 pénètre dans la cheminée C jusqu'au volume V. Le matériau silicium 1 de la fausse grille est ainsi retiré progressivement selon un front périphérique progressant dans le volume V jusqu'aux parois de celui-ci définies par l'espaceur 3. La portion résiduelle de la couche de silice 2 empêche le front de retrait d'atteindre le matériau de silicium du substrat 100, et est appelée, pour cette raison, couche d'arrêt.

Le masque M est retiré.

La portion résiduelle de la couche de silice 2 est alors dissoute par gravure chimique au moyen de la solution à base d'acide fluorhydrique HF déjà utilisée pour la gravure de la couche 2 dans les zones P2. Pour cela, la solution est introduite par la cheminée C puis retirée après un délai de réaction suffisant pour éliminer entièrement la portion résiduelle de la couche 2. Cette seconde étape de retrait de la couche 2 termine l'évidement du volume V après l'évacuation du matériau temporaire 1. Eventuellement, la section de la cheminée C parallèlement à la surface S est un peu élargie lors de cette étape, au niveau du second matériau externe 6, aussi en silice. Par ailleurs, l'abaissement de la surface supérieure du matériau 6 lors de cette étape n'est pas significatif par rapport à l'épaisseur totale du matériau 6.

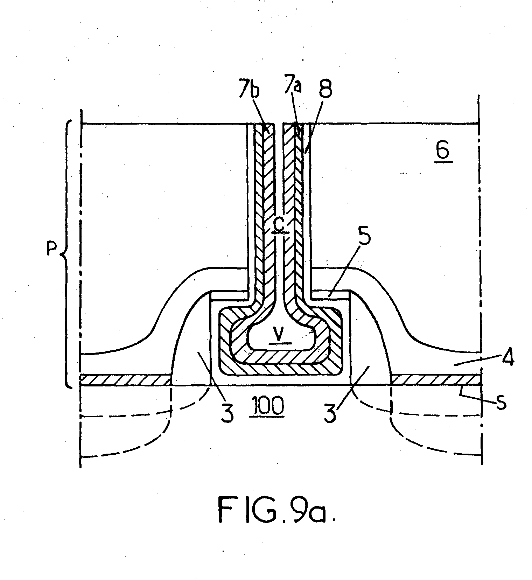

Un matériau de revêtement 8 (figure 9) est ensuite introduit dans le volume V à partir de précurseurs spécifiques amenés par la cheminée C. Ces précurseurs comprennent, par exemple, des molécules organométalliques gazeuses réagissant au contact des parois exposées du volume V et de la cheminée C. Plusieurs procédés de formation du matériau 8 peuvent être utilisés, tels que le dépôt chimique en phase vapeur («chemical vapor deposition» ou CVD) ou un dépôt par couches atomiques superposées, connus de l'Homme du métier. Le matériau de revêtement 8 ainsi formé tapisse le volume V et la cheminée C, ainsi que la surface supérieure du matériau externe 6.

Le matériau 8, destiné à former une isolation électrique entre la grille définitive et le substrat 100, peut-être, par exemple, de l'oxyde d'hafnium HfO₂. Cet oxyde possède en effet un coefficient de permittivité diélectrique particulièrement élevé, favorable à une réduction de l'épaisseur de la couche de revêtement 8, tout en conservant une isolation électrique efficace. L'épaisseur d'oxyde d'hafnium déposée est, par exemple, comprise entre 3 et 5 nanomètres.

Enfin, le matériau de remplissage 7 (figure 9) est formé dans le volume V à partir de précurseurs adaptés introduits par la cheminée C. Le matériau de remplissage 7 est simultanément formé dans le volume V et dans la cheminée C, sur la surface exposée du matériau de revêtement 8. Plusieurs procédés peuvent encore être utilisés pour la formation du matériau 8, dont le dépôt chimique en phase vapeur, le dépôt par couches atomiques superposées, ou encore un procédé de dépôt chimique connu sous l'appellation «electroless». Un tel dépôt «electroless», adapté pour un matériau de remplissage 7 métallique, procède par introduction d'une solution chimique dans la cheminée C. Cette solution comprend au moins un précurseur contenant un atome du métal sous forme oxydée, et un composé réducteur approprié est ajouté à la solution, qui agit comme déclencheur d'une libération de l'atome métallique. A titre d'exemple, le dépôt chimique en phase vapeur et le dépôt par couches atomiques superposées sont particulièrement adaptés pour un matériau 7 de tungstène, et le procédé «electroless» est particulièrement adapté pour un matériau 7 de nickel ou de cobalt.

Il est aussi possible de former un matériau 7 initial dans le volume V de la façon décrite ci-dessus, puis de transformer in situ le matériau 7 initial pour obtenir un matériau 7 final ayant des propriétés particulières. Cette transformation peut être réalisée par chauffage du transistor après la formation du matériau 7 initial, ou/et par mise en contact du matériau 7 initial avec au moins un composé chimique fluide introduit dans le volume V par la cheminée C. A titre d'exemple, le matériau 7 initial peut être de type nitrure de titane TiNₓ, x étant un nombre de stoechiométrie compris entre 0 et 1. x peut ensuite être ajusté par réaction chimique du matériau 7 initial avec un gaz comprenant de l'azote (N₂) et/ou de l'hydrogène (H₂), ou encore de l'ammoniac (NH₃) amené alors que le transistor est porté à une température suffisamment élevée, notamment supérieure à 400°C.

Le matériau 7 est choisi conducteur électrique, de préférence métallique. La partie de matériau 7 déposée dans le volume V correspond à la grille du transistor MOS, et la partie du matériau 7 déposée dans la cheminée constitue une connexion électrique reliant la grille du transistor à la surface supérieure du matériau externe 6. Une épaisseur de 50 nanomètres environ pour le matériau 7 déposé procure une conduction électrique suffisante pour commander la tension électrique de la grille du transistor final.

Plusieurs matériaux métalliques peuvent être sélectionnés pour le matériau 7, en fonction de valeurs du travail de sortie des électrons répertoriées pour ces matériaux. Il peut être notamment avantageux d'établir une symétrie des tensions de déclenchement de transistors MOS obtenus par le procédé de l'invention, de type n ou p selon la nature de la conduction de la grille, opposée au type du dopage du substrat de silicium 100 au niveau de la source et du drain (portions 101-104 du substrat 100). Ainsi, un métal ayant une valeur de travail de sortie située autour de 4 électron-volts, tel que l'aluminium, le cadmium, l'hafnium, l'indium, le magnésium, le tantale, le zirconium, un alliage de titane et de tungstène, etc., est particulièrement adapté pour un transistor MOS de type n, c'est-à-dire dont la source et le drain sont dopés p. A l'inverse, pour un transistor MOS de type p, c'est-à-dire dont la source et le drain sont dopés n, un métal ayant une valeur de travail de sortie située autour de 5,3 électron-volts est particulièrement adapté, tel que l'or, le platine, le palladium, le ruthénium, le rhodium ou le germanium.

Il est notamment possible d'associer sur un même substrat des transistors MOS de types opposés réalisés selon le procédé de l'invention. Pour cela, les portions de substrat constituant les sources et les drains des transistors de chaque type sont implantées successivement lors de deux étapes d'implantation de types opposés, en masquant, de façon connue de l'Homme du métier, les zones du substrat associées aux transistors de l'autre type. Les grilles des transistors de chaque type sont ensuite formées lors de deux étapes de métallisation successives, mettant chacune en oeuvre l'un des métaux de chacune des deux familles précitées. On obtient ainsi un dispositif électrique CMOS («Complementary MOS») à deux métaux de grille («dual metal gate»).

Les matériaux 7 et 8 présents sur la surface supérieure du matériau externe 6 sont retirés par polissage, de façon à obtenir la configuration représentée sur la figure 9.

Deux connexions sont ensuite élaborées au travers des matériaux externes 4 et 6, afin d'établir deux contacts électriques avec les parties de siliciure 9bis respectives de la source et du drain. Pour cela, deux cheminées supplémentaires sont formées à partir de la surface supérieure du matériau 6, en utilisant par exemple une gravure directionnelle analogue à celle mise en oeuvre pour la cheminée C. Ces deux cheminées sont à leur tour comblées de matériau conducteur pour réaliser les connexions électriques.

Dans l'éventualité d'une erreur d'alignement d'un masque de lithographie utilisé pour définir la position des cheminées de source et de drain, l'une de ces deux cheminées peut déboucher en partie à une extrémité du volume V, à cheval sur l'espaceur 3. L'utilisation d'un matériau de masquage 5 particulièrement dense et suffisamment résistant au procédé de gravure directionnelle permet alors d'éviter un court-circuit électrique entre la grille et la source ou le drain, lors du remplissage des cheminées de source et de drain par le matériau conducteur.

De façon analogue, une erreur d'alignement du masque de lithographie utilisé pour définir la position de la cheminée de grille C peut déplacer l'axe de celle-ci parallèlement à la surface S du substrat 100, de sorte que la cheminée C soit située à cheval sur l'espaceur 3, et débouche partiellement sur l'une des zones de siliciure 9bis. Lors du dépôt du matériau de remplissage 7, un court-circuit électrique analogue à celui évoqué ci-dessus peut encore apparaître.

Pour éviter une telle conséquence d'un défaut de positionnement de la cheminée de grille C, le premier matériau externe 4 est choisi de façon à présenter une vitesse de retrait modérée lors de la gravure directionnelle de la cheminée C. Du fait de l'inclinaison des surfaces extérieures de l'espaceur 3 opposées au volume V, lorsque l'espaceur 3 est réalisé de la façon décrite plus haut, la couche de matériau externe 4 présente une épaisseur plus importante dans la portion P2 du substrat autour de l'espaceur 3. La progression, selon la direction D, du front de gravure directionnelle de la cheminée C est alors ralentie dans la portion P2 autour de l'espaceur 3, sur une épaisseur de matériau externe 4 supérieure à l'épaisseur du matériau 4 au-dessus du volume V. Ainsi une cheminée partiellement décalée par rapport au volume V peut néanmoins déboucher sur le volume V sans atteindre aucune des zones de siliciure 9bis. Ce rôle de la couche de premier matériau externe 4, connu sous l'appellation de «borderless», est combiné de façon particulièrement avantageuse avec le procédé de l'invention pour obtenir des transistors de dimensions très réduites avec un bon rendement.

Les dimensions d'une grille réalisée de la façon décrite ci-dessus sont par exemple une largeur comprise entre 15 et 130 nanomètres, et une longueur comprise entre 120 et 200 nanomètres, correspondant au volume V. Une projection d'une telle grille sur la surface S est alors un rectangle, pouvant être par exemple de 25 nanomètres par 180 nanomètres. La figure 9 correspond alors à une section d'une telle grille perpendiculairement à sa longueur. La cheminée C peut être cylindrique de base circulaire, avec un diamètre de 15 nanomètres par exemple, et peut déboucher sur la grille à proximité de l'un de ses deux petits côtés. Eventuellement, plusieurs cheminées peuvent être simultanément utilisées pour une même grille ayant les dimensions précédentes, disposées par exemple à intervalles réguliers sur la longueur de cette grille. L'utilisation de plusieurs cheminées pour la même grille facilite notamment l'étape d'évacuation du matériau temporaire 1, ainsi que les étapes d'introduction et de dépôt des matériaux de revêtement 8 et de remplissage 7 dans le volume V.

Le procédé de l'invention est aussi particulièrement adapté pour la réalisation, au sein d'un même circuit intégré, de transistors MOS ayant des caractéristiques individuelles variées, telles que, par exemple, des valeurs respectives de tension de seuil différentes. Il permet en effet la réalisation de tels transistors en un nombre réduit d'étapes. Le prix de fabrication du circuit comprenant ces transistors de caractéristiques variées est alors plus bas que celui d'un circuit équivalent réalisé selon des procédés connus.

Des valeurs distinctes de tension de seuil d'un transistor MOS réalisé selon l'invention peuvent être obtenues en utilisant deux matériaux conducteurs électriques pour réaliser la grille du transistor. Le matériau de remplissage 7 comprend alors un premier et un second matériaux de remplissage conducteurs électriques introduits successivement dans le volume V, à partir de premiers précurseurs respectifs amenés par la cheminée C. Les premiers et second matériaux de remplissage sont déposés dans le volume V selon l'une des méthodes décrites plus haut en relation avec le matériau de remplissage 7. De façon avantageuse, ils sont déposés dans des chambres successives d'un même tunnel de ligne de fabrication de circuit intégré.

La figure 9a représente un transistor MOS ainsi obtenu. Un tel transistor est identique à celui représenté sur la figure 9, en dehors de la constitution de la grille. Celle-ci est constituée de deux portions de matériaux de remplissage 7a et 7b. Le matériau 7a est disposé sous forme d'une couche recouvrant la couche de revêtement isolante 8 à l'intérieur du volume V. Le matériau 7b est disposé sur la couche de matériau 7a, dans le volume V. Des parties de matériau 7a et 7b déposées sur la surface supérieure du matériau 6 sont retirées de la façon décrite plus haut pour les matériaux 7 et 8.

Le matériau 7a peut être, par exemple, en polysilicium, et la couche correspondante peut avoir une épaisseur comprise entre 2 et 20 nanomètres. Le matériau 7b peut être choisi parmi l'aluminium, le cadmium, l'hafnium, l'indium, le magnésium, le tantale, le zirconium, un alliage de titane et de tungstène, l'or, le platine, le palladium, le ruthénium, le rhodium, le germanium, ou un composé comprenant au moins l'un de ces métaux. Le matériau 7b peut être disposé à l'intérieur du volume V sous forme d'une couche recouvrant la couche de matériau 7a, par exemple d'environ 40 nanomètres d'épaisseur, ou de façon à combler le volume V, ou encore jusqu'à la fermeture de la cheminée C.

Une telle constitution de la grille permet d'ajuster la tension de seuil du transistor MOS, notamment en réalisant la couche de matériau 7a avec une épaisseur faible et en choisissant convenablement le matériau 7b. Lorsque le matériau 7a est du polysilicium, la tension de seuil du transistor obtenu est alors intermédiaire entre celle d'un transistor de même configuration ayant une grille intégralement en polysilicium, et celle d'un transistor de même configuration ayant une grille intégralement en matériau 7b.

Eventuellement, le transistor peut ensuite être chauffé de façon à provoquer une réaction chimique entre les matériaux 7a et 7b. Un unique matériau conducteur résultant de la réaction chimique peut alors constituer la grille du transistor. De cette manière, une grille de siliciure de tungstène, de nickel ou de cobalt est obtenue à partir d'un matériau 7a de silicium et d'un matériau 7b respectivement de tungstène, de nickel ou de cobalt.

Selon un perfectionnement du procédé de l'invention, un circuit intégré en cours de fabrication comprend plusieurs transistors MOS pour lesquels l'étape d'introduction du matériau de remplissage par leurs cheminées respectives, afin de constituer leurs grilles respectives, n'a pas encore été effectuée. Ces transistors MOS encore dépourvus de grilles ont des cheminées respectives ayant des sections différentes, considérées dans un plan parallèle à la surface supérieure du matériau 6. Ils peuvent être, par exemple, répartis en un groupe de transistors à cheminées larges, c'est-à-dire à grandes sections, et un groupe de transistors à cheminées étroites, c'est-à-dire à petites sections. Les cheminées des transistors des deux groupes peuvent être réalisées en une unique étape de gravure, en utilisant un masque M formé sur le matériau 6 qui comporte une ouverture pour chaque cheminée, correspondant à la section de celle-ci.

On réalise alors le remplissage des volumes V respectifs des transistors en deux étapes successives. Lors d'une première étape, on introduit le premier matériau 7a, par exemple du polysilicium, dans les volumes V, à partir de premiers précurseurs amenés par les cheminées C respectives des transistors. La durée de cette première étape est choisie de sorte que les cheminées C étroites sont essentiellement fermées par le matériau 7a, alors que les cheminées C larges restent essentiellement ouvertes entre la surface d'accès et les volumes V respectifs des transistors.

Lors d'une seconde étape du remplissage, on expose la surface d'accès du circuit aux premiers précurseurs du matériau 7b. Le matériau 7b est alors formé dans les volumes V des transistors dont les cheminées respectives C sont restées essentiellement ouvertes à l'issue de la première étape du remplissage, c'est-à-dire les transistors à cheminées larges. Des portions du matériau 7b peuvent aussi être déposées lors de cette seconde étape dans une partie supérieure des cheminées étroites, si la fermeture des cheminées étroites par le polysilicium lors de la première étape du remplissage est localisée en dessous du niveau de la surface d'accès. De telles portions sont alors situées dans les cheminées étroites à distance des grilles correspondantes, et n'ont pas d'influence sur le comportement électrique des transistors ainsi obtenus. Les transistors à cheminées étroites possèdent donc des grilles constituées seulement de polysilicium, alors que les transistors à cheminées larges possèdent des grilles mixtes constituées de polysilicium et de matériau 7b. Des transistors de deux types sont ainsi réalisés dans le circuit, différenciés par les dimensions des sections de leurs cheminées respectives, sans nécessiter d'opérations de masquages supplémentaires.

De même que précédemment, le transistor peut éventuellement être ensuite chauffé, de façon à provoquer une réaction chimique entre les matériaux 7a et 7b dans les volumes V respectifs des transistors à cheminées larges.

Il est en outre possible de combiner une telle réalisation de transistors MOS à grilles mixtes avec l'utilisation de plusieurs seconds matériaux de remplissage distincts associés à des transistors à cheminées larges différents d'un même circuit. Pour cela, la première étape de remplissage est inchangée. on utilise ensuite, pour la seconde étape de remplissage, une combinaison d'opérations de masquages et de dépôts de seconds matériaux de remplissage analogue à celle décrite plus haut pour associer sur un même substrat des transistors MOS de types opposés.

Le procédé de l'invention peut aussi être utilisé pour la réalisation de pistes de transmission rapide de signaux électriques. De telles pistes sont obtenues en réduisant les interactions capacitives et inductives entre les parties métalliques qui constituent les pistes elles-mêmes et d'autres matériaux proches de ces pistes. En particulier, la disposition de matériaux à faible permittivité diélectrique à proximité des pistes permet d'accroître significativement la vitesse de transmission des signaux électriques portés par les pistes.

Les pistes métalliques peuvent être élaborées en utilisant le procédé Damascène, ou le procédé dérivé «dual Damascène», connu de l'Homme du métier. A fin d'en diminuer la résistance ohmique, le matériau métallique des pistes est préférablement élaboré à haute température, par exemple d'au moins 400°C, ou porté à une telle température après son élaboration, afin de lui conférer une structure cristallisée. Or des matériaux à faible permittivité diélectrique tels que des polymères sont dégradés par un chauffage à une température supérieure à 250°C environ.

La méthode de réalisation de pistes de transmission rapide de signaux électriques décrite ci-après résulte de l'utilisation du procédé de l'invention, et permet l'agencement d'un volume de polymère en dessous de pistes métalliques au moins partiellement cristallisées.

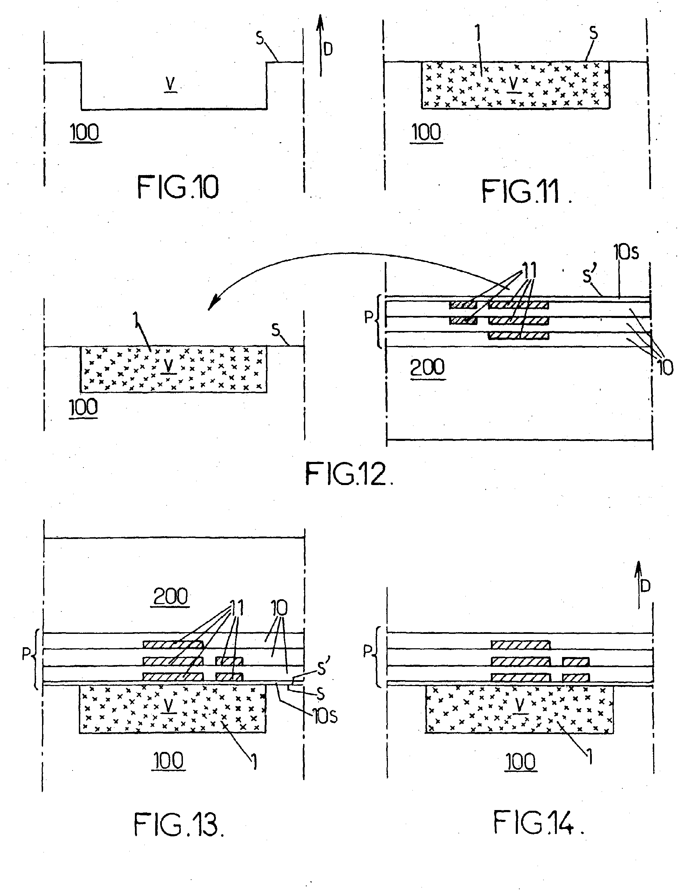

Selon la figure 10, un volume V est formé dans un substrat 100 par évidement à partir d'une surface plane S de ce substrat. Le substrat 100 est par exemple en silicium, et le volume V est évidé selon une méthode connue de l'Homme du métier, comprenant, par exemple, un recouvrement de la surface S en dehors du volume V par un masque de résine lithographié et une exposition de la surface S à un plasma de gravure sèche. Ce plasma de gravure peut contenir des molécules d'hexafluorure de soufre SF₆ ou de chlorure d'hydrogène HCl, et est mis en oeuvre de façon à obtenir une gravure directionnelle rapide du silicium du substrat 100.

Un alliage de silicium et de germanium 1 est alors déposé dans le volume V de façon à remplir intégralement le volume V (figure 11). Un polissage de la surface S est alors effectué pour retirer un excédent de l'alliage présent sur la surface S, et pour obtenir une surface S finale rigoureusement plane.

Une portion P de circuit incorporant des pistes métalliques est par ailleurs élaborée sur un autre substrat 200, par exemple aussi en silicium (figure 12). Cette portion P comprend par exemple trois couches de silice SiO₂ 10 superposées, au sein desquelles des pistes métalliques 11 sont réalisées, par exemple en utilisant le procédé Damascène. Les pistes 11 peuvent être en cuivre ou en aluminium, notamment. Les couches 10 et les pistes 11 portées par le substrat 200 sont alors chauffées, à une température supérieure à 400°C par exemple, afin de créer une cristallisation du matériau métallique des pistes. Grâce au chauffage de la portion P alors que celle-ci est encore portée par le substrat 200, différents composants non représentés portés par le substrat 100 et susceptibles d'être dégradés à haute température ne sont pas soumis à ce chauffage, et sont ainsi préservés d'un risque de dégradation thermique. De tels composants comprennent par exemple des zones du substrat 100 implantées d'éléments de dopage qui pourraient diffuser thermiquement en dehors de leur zone d'implantation initiale.

De façon préférée, la portion P est recouverte d'une couche de silice SiO₂ 10s de faible épaisseur, disposée sur la face supérieure de la portion P opposée au substrat 200.

Selon la technique dite de collage moléculaire (ou «wafer bonding») connue de l'Homme du métier, la portion P est appliquée par la surface supérieure S' de la couche 10s, opposée au substrat 200, sur la surface S du substrat 100 (figure 12). En l'absence de pollutions des surfaces S et S', des liaisons chimiques sont alors formées entre les matériaux découverts au niveau des surfaces S et S', mis en contact entre eux. Ces liaisons sont notamment particulièrement nombreuses entre le silicium du substrat 100 et la silice de la couche 10s. Les substrats 100 et 200 sont alors solidarisés entre eux (figure 13). Les pistes métalliques 11 ont été initialement agencées sur le substrat 200 de façon à se trouver, à l'issue de l'étape de collage moléculaire, au dessus du volume V ménagé dans le substrat 100.

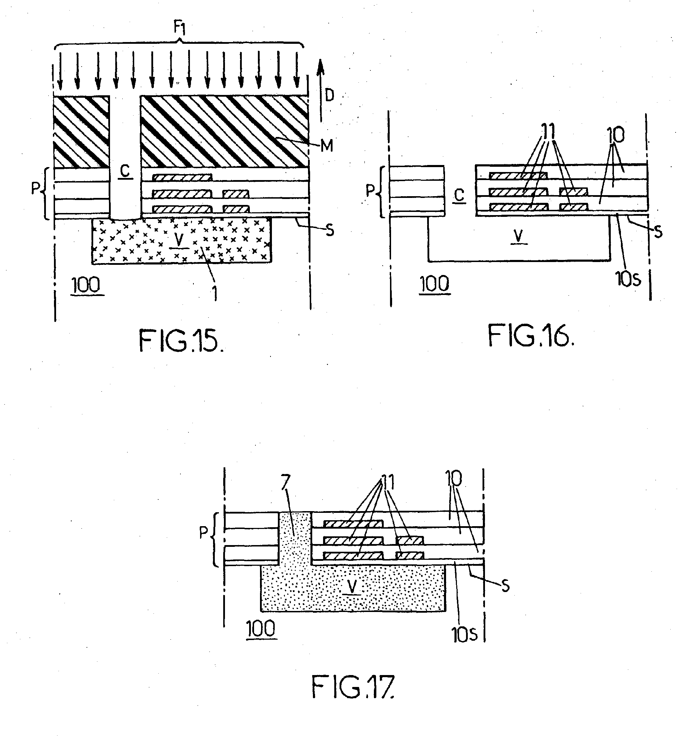

Le substrat 200 est alors retiré. Ce retrait comprend par exemple une première phase d'abrasion mécanique du substrat 200 sur presque toute l'épaisseur du substrat 200, cette épaisseur étant considérée selon la direction D. Il comprend ensuite une seconde étape de gravure sèche, de façon à retirer l'épaisseur résiduelle de silicium du substrat 200, jusqu'à découvrir la surface de la portion P opposée au substrat 100. La configuration représentée à la figure 14 est alors obtenue.

De même que dans l'exemple de la réalisation d'un transistor MOS, une cheminée C parallèle à la direction D est formée au travers de la portion P, depuis la surface supérieure de la portion P jusqu'au volume V. Pour cela, un flux F1 de particules de gravure sèche directionnelle est envoyé au travers d'un masque de résine M déposé sur la portion P, avec une ouverture définissant la section de la cheminée C (figure 15). L'ouverture du masque M est par ailleurs agencée de façon à ce que la cheminée C traverse la portion P en dehors des pistes métalliques 11. La gravure directionnelle est poursuivie pendant une durée déterminée, de sorte que la cheminée C formée atteigne le volume V rempli d'alliage silicium-germanium.

Le masque de gravure M est retiré.

Une solution de gravure sélective de l'alliage silicium-germanium est ensuite introduite par la cheminée C, jusqu'au volume V. De façon connue de l'Homme du métier, une solution aqueuse oxydante composée de 40 millilitres d'acide nitrique HNO₃ à 70%, de 20 millilitres de peroxyde d'hydrogène H₂O₂ et 5 millilitres d'acide fluorhydrique HF à 5% provoque la dissolution de l'alliage silicium-germanium du volume V sans altérer le matériau silicium du substrat 100, ni les autres matériaux de la portion P (figure 16).

Un polymère à faible permittivité diélectrique est alors introduit par la cheminée C et déposé dans le volume V, en tant que matériau de remplissage 7 (figure 17). D'une façon connue, le polymère peut être évaporé thermiquement à partir d'une source solide de ce polymère placée dans un creuset chauffé par effet Joule. Des molécules du polymère libérées sous forme gazeuse pénètrent alors dans la cheminée C et dans le volume V. Eventuellement, la cheminée C peut aussi être comblée de polymère lors de cette étape de dépôt. Le volume V ainsi rempli s'étend sous les pistes métalliques 11, ainsi que de part et d'autre de la projection des pistes 11 sur la surface S selon la direction D. Le volume V n'est alors le siège que d'interactions électrostatiques très réduites avec les pistes 11 lorsque celles-ci transmettent des signaux électriques.

De façon générale, le matériau de remplissage 8 peut être un matériau diélectrique à faible permittivité diélectrique, notamment inférieure à 1,40. Outre un polymère, le matériau de remplissage 8 peut être un composé du type oxycarbure de silicium SiOₓC_{y}, où x et y sont les coefficients stoechiométriques respectivement de l'oxygène et du carbone par rapport au silicium. Le matériau de remplissage 8 peut encore être du carbone ayant une structure analogue à celle du diamant («Diamond Like Carbon»), connu de l'Homme du métier sous l'acronyme DLC.

Deux mises en oeuvre du procédé de l'invention ont été décrites, respectivement dans le cadre de l'élaboration de transistors MOS et dans celui de la réalisation de pistes de transmission rapide de signaux électriques. Ces deux mises en oeuvre du procédé de l'invention n'ont été prises qu'à titre d'exemples, de façon non limitative, étant entendu que le procédé peut être utilisé pour la réalisation de composants électroniques intégrés très variés.

## Revendications

1. Procédé de réalisation d'une grille d'un transistor à effet de champ sur une surface (S) sensiblement plane d'un substrat (100), le procédé comprenant les étapes suivantes :
a- couvrir la surface (S) du substrat (100) d'une portion (P) délimitant avec le substrat un volume (V) rempli au moins partiellement d'un matériau temporaire (1) ;
b- évacuer le matériau temporaire (1) dudit volume par une cheminée, (C) s'étendant entre ledit volume (V) et une surface d'accès ;
c- introduire un matériau de remplissage conducteur électrique (7) dans ledit volume (V) à partir de premiers précurseurs amenés par la cheminée (C), de façon à former la grille du transistor à effet de champ.

2. Procédé selon la revendication 1, dans lequel la cheminée (C) possède une section parallèle à la surface (S) du substrat sensiblement plus petite qu'une projection dudit volume (V) sur la surface du substrat.

3. Procédé selon la revendication 1 ou 2, dans lequel une partie au moins de ladite portion (P) comprend des matériaux formés sur la surface (S) du substrat (100).

4. Procédé selon l'une quelconque des revendications 1 à 3, comprenant les deux étapes suivantes effectuées avant l'étape a :
- retirer une partie d'un matériau du substrat (100) correspondant audit volume (V) ;
- remplir au moins partiellement ledit volume (V) par le matériau temporaire (1).

5. Procédé selon l'une quelconque des revendications 1 à 3, comprenant l'étape suivante effectuée avant l'étape a :
- former un motif sur la surface (S) du substrat (100) comprenant ledit volume (V) rempli au moins partiellement par le matériau temporaire (1).

6. Procédé selon l'une quelconque des revendications précédentes, dans lequel la cheminée (C) est formée par retrait d'au moins un matériau (6) externe audit volume (V), entre la surface d'accès et ledit volume.

7. Procédé selon la revendication 6, dans lequel la formation de la cheminée (C) comprend une étape de gravure directionnelle par plasma d'au moins ledit matériau externe (6).

8. Procédé selon l'une quelconque des revendications précédentes, dans lequel le matériau temporaire (1) comprend du silicium, un alliage de silicium et de germanium, de la silice ou du nitrure de silicium.

9. Procédé selon l'une quelconque des revendications précédentes, dans lequel l'étape b comprend une étape de gravure isotrope du matériau temporaire (1), par plasma ou au moyen d'une solution incorporant des réactifs chimiques.

10. Procédé selon l'une quelconque des revendications précédentes, dans lequel ledit volume (V) est délimité, au moins en partie, par au moins un matériau (2, 3) résistant à l'évacuation du matériau temporaire.

11. Procédé selon la revendication 10, comprenant en outre, entre les étapes b et c, une étape de retrait d'un premier (2) des matériaux résistants à l'évacuation du matériau temporaire, ledit volume (V) correspondant à une réunion de l'espace occupé initialement au moins partiellement par le matériau temporaire (1) et de l'espace occupé par une portion au moins dudit premier matériau résistant à l'évacuation du matériau temporaire.

12. Procédé selon la revendication 10 ou 11, dans lequel un second (3) des matériaux résistants à l'évacuation du matériau temporaire (1) entoure ledit volume (V) parallèlement à la surface (S) du substrat et forme un espaceur disposé entre la grille et une source dudit transistor d'une part, et entre la grille et un drain dudit transistor d'autre part.

13. Procédé selon la revendication 12, dans lequel un premier matériau externe (4) est formé avant l'étape b de façon à recouvrir ledit second matériau (3) résistant à l'évacuation du matériau temporaire et une partie au moins dudit volume (V), d'un côté opposé au substrat (100).

14. Procédé selon l'une quelconque des revendications précédentes, comprenant en outre un chauffage du substrat effectué avant l'étape c.

15. Procédé selon l'une quelconque des revendications précédentes, dans lequel, lors de l'étape c, le matériau de remplissage (7) est simultanément formé dans ledit volume (V) et dans la cheminée (C).

16. Procédé selon la revendication 15, dans lequel la cheminée (C) au moins partiellement remplie de matériau conducteur constitue une connexion électrique reliant la grille du transistor.

17. Procédé selon l'une quelconque des revendications précédentes, comprenant en outre, après l'étape c, une transformation in situ du matériau de remplissage (7) , par chauffage et/ou mise en contact du matériau de remplissage (7) avec au moins un composé chimique fluide introduit dans ledit volume (V) par la cheminée (C).

18. Procédé selon l'une quelconque des revendications précédentes, dans lequel le matériau de remplissage (7) est à base de polysilicium, de nitrure de titane, d'aluminium, de cadmium, d'hafnium, d'indium, de magnésium, de tantale, de zirconium, d'un alliage de titane et de tungstène, d'or, de platine, de palladium, de ruthénium, de rhodium ou de germanium.

19. Procédé selon l'une quelconque des revendications précédentes, dans lequel le matériau de remplissage comprend un premier (7a) et un second (7b) matériaux de remplissage introduits successivement dans ledit volume (V) à partir de premiers précurseurs respectifs amenés par la cheminée (C).

20. Procédé selon l'une quelconque des revendications précédentes, dans lequel l'étape c comprend :
c1- une introduction d'un premier matériau de remplissage (7a) dans ledit volume (V) à partir de premiers précurseurs du premier matériau de remplissage amenés par la cheminée (C), de sorte que la cheminée (C) est essentiellement fermée ou reste essentiellement ouverte entre la surface d'accès et ledit volume (V), à l'issue de l'introduction du premier matériau de remplissage (7a), et
c2- une exposition de la surface d'accès à des premiers précurseurs d'un second matériau de remplissage, de façon à former le second matériau de remplissage (7b) dans ledit volume (V) si la cheminée (C) est restée essentiellement ouverte à l'issue de l'introduction du premier matériau de remplissage (7a).

21. Procédé selon la revendication 19 ou 20, dans lequel ledit premier matériau de remplissage (7a) est à base de polysilicium, et dans lequel ledit second matériau de remplissage (7b) est à base d'aluminium, de cadmium, d'hafnium, d'indium, de magnésium, de tantale, de zirconium, d'un alliage de titane et de tungstène, d'or, de platine, de palladium, de ruthénium, de rhodium ou de germanium.

22. Procédé selon l'une quelconque des revendications 19 à 21, comprenant en outre une étape de chauffage du transistor de façon à provoquer une réaction chimique entre les premier (7a) et second (7b) matériaux de remplissage à l'intérieur dudit volume (V).

23. Procédé selon l'une quelconque des revendications précédentes, comprenant en outre, entre les étapes b et c, une étape d'introduction d'un matériau de revêtement (8) dans ledit volume (V) à partir de seconds précurseurs amenés par la cheminée (C).

24. Procédé selon la revendication 23, dans lequel le matériau de revêtement (8) forme une isolation électrique entre la grille et le substrat.

25. Procédé selon la revendication 23 ou 24, dans lequel le matériau de revêtement (8) comprend un oxyde d'hafnium.

26. Procédé selon l'une quelconque des revendications précédentes, dans lequel le substrat (100) est à base de silicium, l'étape a du procédé comprenant les étapes suivantes :
a1- déposer, sur la surface (S) du substrat, un premier matériau (2) résistant à l'évacuation du matériau temporaire ;
a2- déposer le matériau temporaire (1) par-dessus le premier matériau résistant à l'évacuation du matériau temporaire, d'un côté opposé au substrat ;
a3- déposer un matériau de masquage (5) sur le matériau temporaire, d'un côté opposé au substrat ;
a4- retirer le matériau de masquage et le matériau temporaire en dehors d'une première zone (P1) du substrat;
a5- retirer ledit premier matériau (2) résistant à l'évacuation du matériau temporaire, dans des secondes zones (P2) du substrat ;
a6- déposer un second matériau (3) résistant à l'évacuation du matériau temporaire dans au moins une troisième zone (P3) du substrat entourant ladite première zone (P1), le second matériau résistant à l'évacuation du matériau temporaire étant disposé jusqu'à une hauteur, selon une direction (D) perpendiculaire à la surface (S) du substrat, d'une surface du matériau de masquage (5) opposée au substrat ;
a7- déposer un métal (9) de façon sensiblement uniforme dans lesdites première, secondes et troisième zones ;
a8- chauffer de façon à provoquer la formation d'un siliciure du métal (9bis) dans lesdites secondes zones (P2), en dehors de ladite troisième zone (P3) ;
a9- éliminer le métal (9) résiduel ;
a10- déposer un premier matériau externe (4) de façon sensiblement uniforme dans lesdites première (P1) et troisième (P3) zones, et dans une quatrième zone du substrat entourant ladite troisième zone ;

27. Procédé selon la revendication 26, dans lequel l'étape a comprend en outre l'étape suivante :
a11- recouvrir le premier matériau externe (4) par un second matériau externe (6).

28. Procédé selon la revendication 26 ou 27, dans lequel le premier matériau (2) résistant à l'évacuation du matériau temporaire est à base de silice, et dans lequel le second matériau résistant à l'évacuation du matériau temporaire (3) et le premier matériau externe (4) sont à base de nitrure de silicium.

29. Procédé selon l'une quelconque des revendications 26 à 28, dans lequel le matériau de masquage (5) est à base de silice ou de nitrure de silicium.

30. Transistor à effet de champ comprenant une grille réalisée par un procédé selon l'une quelconque des revendications précédentes.

31. Dispositif électrique comprenant un transistor selon la revendication 30.
